# EUROPEAN PATENT APPLICATION

(11) **EP 4 796 281 A1**
(43) Date of publication of application: **26.08.2026**
(21) Application number: 24879823.3
(22) Date of filing: 18.10.2024
(51) Int. Cl.: B29C 45/02, B29C 31/04, B29C 45/17, H01L 21/56

(54) **TABLET SUPPLY DEVICE, RESIN SEALING DEVICE, AND TABLET SUPPLY METHOD**

(30) Priority: 18.10.2023 JP 2023179581
(71) Applicant: Yamaha Robotics Co., Ltd., Musashimurayama-shi, Tokyo 208-8585 (JP)
(72) Inventor: NAKAYAMA, Eiji, Musashimurayama-shi, Tokyo 208-8585 (JP); USUDA, Naoyuki, Musashimurayama-shi, Tokyo 208-8585 (JP); NAGUMO, Norio, Musashimurayama-shi, Tokyo 208-8585 (JP); FUKUSHIMA, Hidehiko, Musashimurayama-shi, Tokyo 208-8585 (JP); YAMAGIWA, Kyohei, Musashimurayama-shi, Tokyo 208-8585 (JP); SHIMODAIRA, Hajime, Musashimurayama-shi, Tokyo 208-8585 (JP)
(74) Representative: Becker, Eberhard
(86) International application number: PCT/JP2024/037200
(87) International publication number: WO 2025/084403

(57) **Abstract**

Provided is a technology related to a tablet supply device (10) that makes it so that dust does not readily diffuse into a resin sealing device (1). The tablet supply device (10) comprises a hopper (16) that supplies resin tablets (T) for transfer molding. The hopper 16 comprises a funnel part (61) that can retain the resin tablets (T) and a bottom part (62) that catches resin tablets (T) that have fallen from the funnel part (61). The bottom part (62) is provided with a first sieve (11) that does not allow passage of the resin tablets (T) but does allow passage of dust that is smaller than the resin tablets (T).

## Description

### Technical Field

The present invention relates to a tablet supply device and a resin sealing device, as well as a tablet supply method using these.

### Background Art

A resin sealing device includes a mold that seals a workpiece using resin obtained by melting resin tablets, a loader that carries the workpiece and resin tablets into each mold, a tablet supply device that supplies resin tablets to the loader, etc. For example, Patent Document 1 discloses a resin tablet supply unit that supplies resin tablets.

### Related Art Document

### Patent Document

Patent Document 1: Japanese Patent Application Laid-Open No. 2001-300978

### SUMMARY OF THE INVENTION

### Problem to be Solved by the Invention

When solidifying a powdered resin material into tablet form to manufacture resin tablets, the resin material that is not solidified may become resin debris and adhere to the resin tablets. When transporting resin tablets, resin falling off or chipping from the resin tablets due to impact may become resin debris. Therefore, the resin tablets fed into the tablet supply device include resin tablets with dust such as resin debris adhered thereto. When such resin tablets move within the resin sealing device, dust may fall off. If such dust disperses within the resin sealing device and adheres to sensors, workpieces, and molds, it may result in defects in resin sealing.

The present invention has been made in view of such problems, and aims to provide a technology related to a tablet supply device that suppresses dust from dispersing within a resin sealing device.

### Means for Solving the Problem

A tablet supply device according to one aspect of the present invention includes a hopper that supplies resin tablets used for transfer molding. The hopper includes a funnel part that is capable of storing resin tablets, and a bottom part that catches resin tablets that have fallen from the funnel part. The bottom part includes a sieve that does not allow resin tablets to pass through but allows dust smaller than resin tablets to pass through.

A tablet supply method according to one aspect of the present invention includes vibrating a funnel part in which resin tablets are stored to drop the resin tablets to a bottom part, and sifting resin tablets and dust that has fallen from the funnel part together with the resin tablets by a sieve provided in the bottom part.

A tablet supply device according to another aspect of the present invention includes a hopper that supplies resin tablets used for transfer molding, and an alignment device that aligns resin tablets supplied from the hopper. The alignment device includes a transport path that transports resin tablets. At least a partial region of the transport path is provided with a sieve that does not allow resin tablets to pass through but allows dust smaller than resin tablets to pass through.

A tablet supply method according to another aspect of the present invention includes transporting resin tablets supplied from a hopper along a transport path, aligning resin tablets by a guide provided on the transport path, and sifting resin tablets and dust being transported together with the resin tablets by a sieve provided on the transport path.

### Effects of the Invention

According to the present invention, it is possible to provide a technology related to a tablet supply device that suppresses dust from dispersing within a resin sealing device.

### BRIEF DESCRIPTION OF THE DRAWINGS

[FIG. 1] FIG. 1 is a rear view showing an example of the resin sealing device including the tablet supply device according to one embodiment of the present invention.
[FIG. 2] FIG. 2 is a rear view showing an example of the tablet supply device according to one embodiment of the present invention.
[FIG. 3] FIG. 3 is a perspective view of the tablet supply device shown in FIG. 2 as viewed obliquely from above.
[FIG. 4] FIG. 4 is a side view of the tablet supply device shown in FIG. 2 as viewed from the out-module side.
[FIG. 5] FIG. 5 is a plan view showing the tablet supply device with the lid body shown in FIG. 3 removed.
[FIG. 6] FIG. 6 is a perspective view showing the tablet supply device with the funnel part shown in FIG. 5 removed.
[FIG. 7] FIG. 7 is a plan view showing the tablet supply device with the hopper shown in FIG. 5 removed.
[FIG. 8] FIG. 8 is a flowchart showing an example of the tablet supply method using the tablet supply device according to one embodiment of the present invention.
[FIG. 9] FIG. 9 is a flowchart showing another example of the tablet supply method using the tablet supply device according to one embodiment of the present invention.

### DESCRIPTION OF THE EMBODIMENTS

Preferred embodiments of the present invention will be described with reference to the accompanying figures. In the figures, components denoted by the same reference numerals have the same or similar configurations. Each figure is provided with an orthogonal coordinate system composed of X-axis, Y-axis, and Z-axis to easily clarify the relationship between the figures and to help understand the positional relationship of each member. The plane including the X-axis and Y-axis is referred to as the "XY plane," and the direction of the Z-axis arrow is described as upward and the direction opposite to the Z-axis arrow is described as downward. When viewed from the front side of the resin sealing device 1, the X-axis direction is, for example, the left-right direction, and the Y-axis direction is, for example, the front-rear direction. Hereinafter, the present invention will be described in detail with reference to the figures.

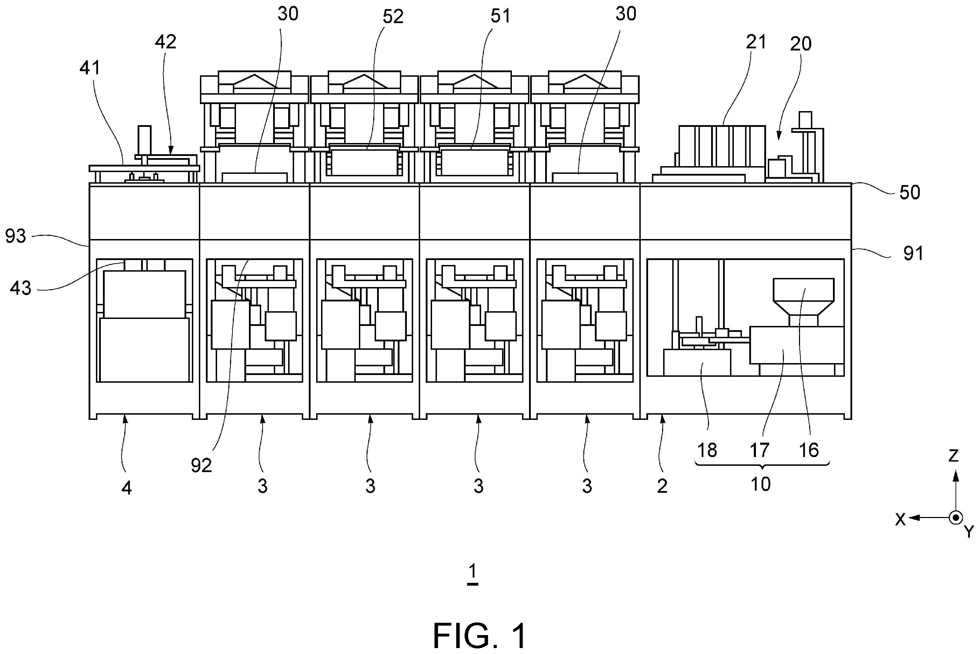

FIG. 1 is a rear view showing an example of a resin sealing device 1 including a tablet supply device 10 according to one embodiment of the present invention. The resin sealing device 1 according to the present embodiment is a resin sealing device for sealing a workpiece with resin, and as shown in FIG. 1, the resin sealing device 1 includes at least a tablet supply device (tablet loader) 10. The resin sealing device 1 may further include, as optional configurations, a workpiece supply device 20, a press module 3, a loader 51, an unloader 52, a degater 41, a workpiece storage device 42, and the like.

The tablet supply device 10 supplies resin tablets to the loader 51. The resin constituting resin tablets is, for example, a thermosetting resin such as epoxy resin. The resin tablets are formed by shaping a resin material into predetermined size and shape, and in the present embodiment, resin tablets are formed into a columnar shape with predetermined height and diameter by tableting (compressing a powdered resin material).

The workpiece supply device 20 takes out a workpiece that has not been sealed with resin from a supply magazine 21 and supplies the workpiece to the loader 51. The loader 51 transports the workpiece and resin tablets supplied from the workpiece supply device 20 and the tablet supply device 10 to a mold (resin sealing mold) 30 of the press module 3.

The press module 3 sandwiches and pressurizes the supplied workpiece to perform resin sealing (molding). The mold 30 is a mold for transfer molding, and in the case of pressurizing the resin tablets supplied to and heated in the pot of the mold 30 with a plunger and further heating and pressurizing the same with the cull, the resin that has been formed into tablet form softens and melts, and the resin moves from the cull through the runner to the cavity in communication. The workpiece is placed in the cavity by the loader 51. As the resin continues to be further heated in the cavity, the resin hardens over time and seals the workpiece.

The unloader 52 takes out the resin-sealed workpiece from the mold 30 and transports the resin-sealed workpiece to the degater 41. The degater 41 separates unnecessary resin from the resin-sealed workpiece. The workpiece storage device 42 catches the workpiece from which unnecessary resin has been separated from the degater 41 and stores the workpiece in a storage magazine 43. In the following description, the portion combining the tablet supply device 10 and the workpiece supply device 20 may be referred to as an in-module 2, and the portion combining the degater 41 and the workpiece storage device 42 may be referred to as an out-module 4.

In the illustrated example, the in-module 2, multiple press modules 3, and the out-module 4 are arranged along the X-axis direction. The multiple press modules 3 are arranged in one row from the in-module 2 toward the out-module 4. In the illustrated example, the resin sealing device 1 includes four press modules 3. The number of press modules 3 is not limited to the illustrated example and may be changed as appropriate.

The out-module 4 is disposed on the opposite side from the in-module 2 as viewed from any press module 3. The in-module 2 and the out-module 4 may be disposed on the same side as viewed from any press module 3. The loader 51 and the unloader 52 are configured to be movable along a guide rail 50 extending in the X-axis direction.

As shown in FIG. 1, the in-module 2 is divided vertically by a horizontally extending frame 91. Similarly, each press module 3 and the out-module 4 are divided vertically by horizontally extending frames 92 and 93. In the illustrated example, the resin sealing device 1 is divided vertically by the frames 91, 92, and 93 at the same height.

The aforementioned tablet supply device 10 is disposed in the lower space. The tablet supply device 10 includes a hopper 16 that supplies resin tablets, an alignment device 17 that aligns resin tablets supplied from the hopper 16 in a predetermined orientation, a lifting device 18 that catches resin tablets from the alignment device 17 and delivers the resin tablets to the loader 51 waiting in the upper space of the in-module 2, and the like. In the present embodiment, the alignment device 17 aligns columnar resin tablets in one row so that the central axes of the resin tablets are oriented in the same direction.

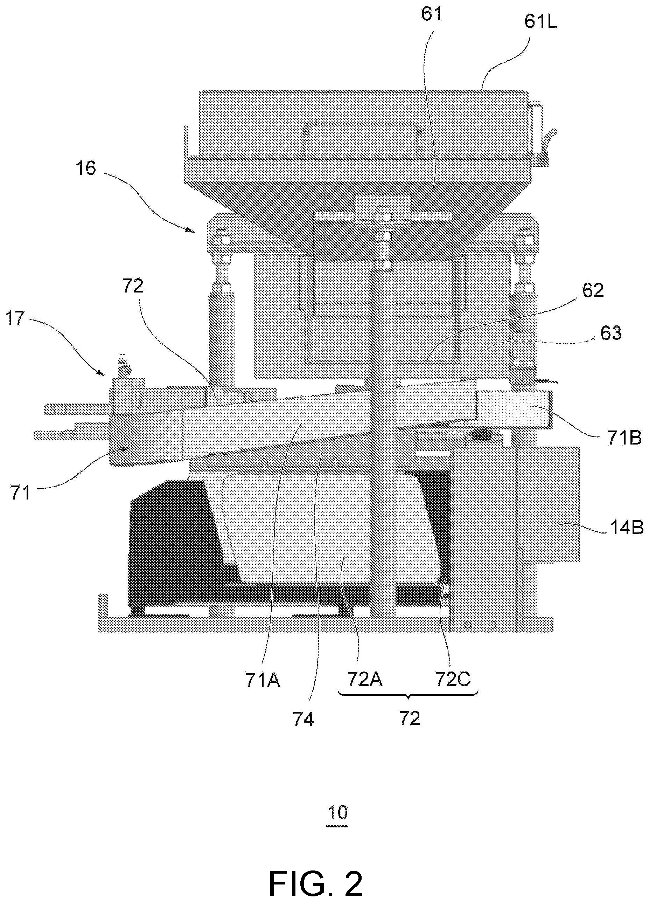

FIG. 2 is a rear view showing an example of the tablet supply device 10 according to one embodiment of the present invention. As shown in FIG. 2, the aforementioned hopper 16 includes a funnel part 61 that is capable of storing resin tablets, a bottom part (receiving tray) 62 that catches resin tablets that have fallen from the funnel part 61, a first vibration device 63 that drops resin tablets in the funnel part 61 to the bottom part 62 by vibrating the funnel part 61, and the like.

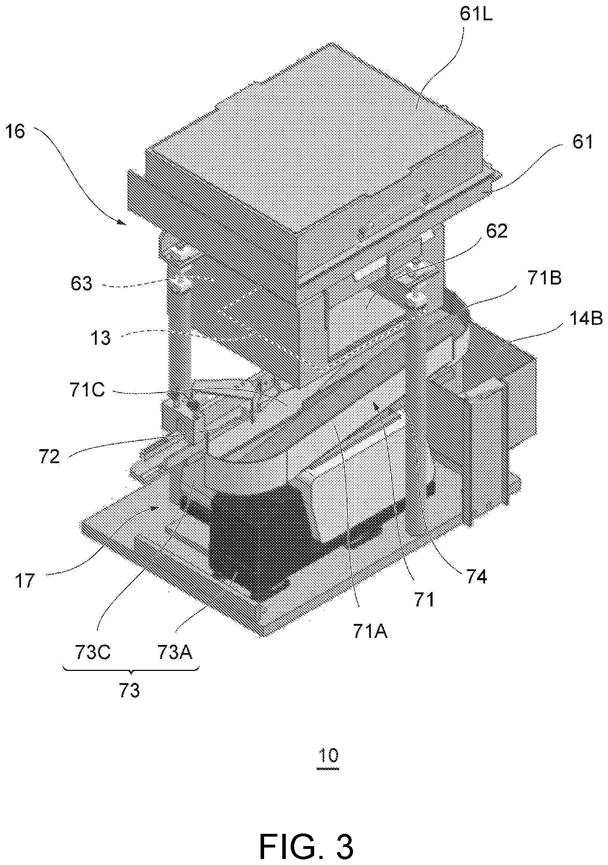

FIG. 3 is a perspective view of the tablet supply device 10 shown in FIG. 2 as viewed obliquely from above. The aforementioned alignment device 17 includes a transport path 71 provided with a guide 72 that regulates the orientation of resin tablets, a second vibration device 73 that transports resin tablets in the transport path 71 by vibrating the transport path 71, and the like.

The resin tablets supplied from the hopper 16 are transported along the transport path 71. The transport path 71 includes a first linear part 71A, a corner part 71B, and a second linear part 71C. The first linear part 71A extends substantially parallel to the X-axis and has a strip-shaped surface that is slightly inclined to face upward as it progresses from the out-module 4 toward the in-module 2. The second linear part 71C extends parallel to the X-axis direction and has a strip-shaped surface parallel to the XY plane.

The corner part 71B has a 90° fan-shaped surface parallel to the XY plane and connects the end of the first linear part 71A with the end of the second linear part 71C. Since the transport path 71 transports resin tablets toward the guide 72 provided in the second linear part 71C, the transport path 71 circulates resin tablets counterclockwise within the transport path 71 in the order of the first linear part 71A, the corner part 71B, and the second linear part 71C.

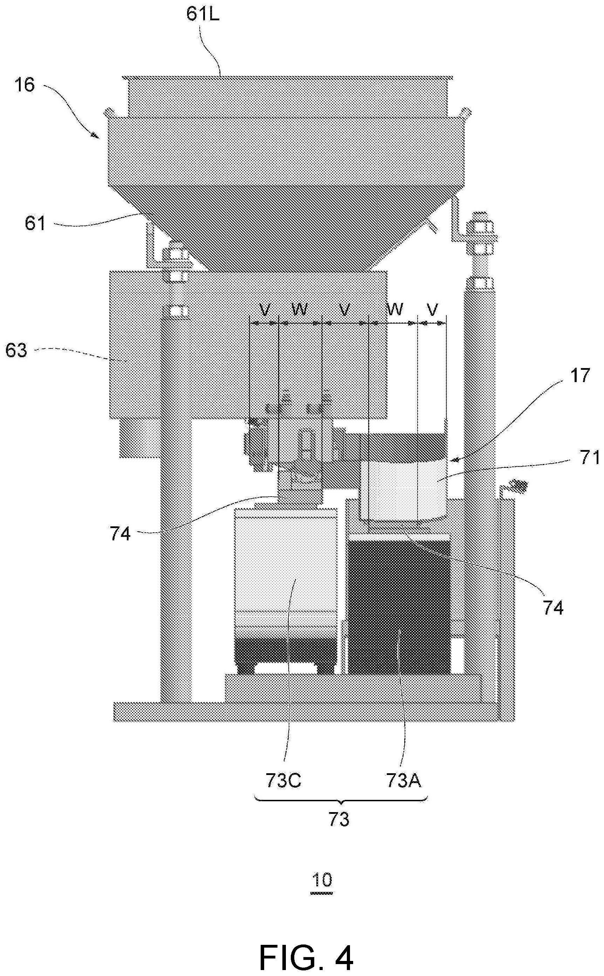

FIG. 4 is a side view of the tablet supply device 10 shown in FIG. 2 as viewed from the out-module 4 side. As shown in FIG. 4, the second vibration device 73 includes a first vibration part 73A and a second vibration part 73C. The first vibration part 73A and the second vibration part 73C transport resin tablets in opposite directions to each other for resin tablets to circulate.

To be more specific, the first vibration part 73A vibrates the first linear part 71A to transport resin tablets in the direction from the out-module 4 to the in-module 2 (leftward when viewed from the front side of the resin sealing device 1). The second vibration part 73C vibrates the second linear part 71C to transport resin tablets in the direction from the in-module 2 to the out-module 4 (rightward when viewed from the front side of the resin sealing device 1).

As shown in FIG. 4, the transport path 71 includes a non-overlapping region V that does not overlap in plan view with a connection part 74 between the transport path 71 and the second vibration device 73, and an overlapping region W that overlaps in plan view with the connection part 74. Second sieves 12A and 12B, which will be described later, are provided in the non-overlapping region V that does not overlap with the connection part 74 in plan view.

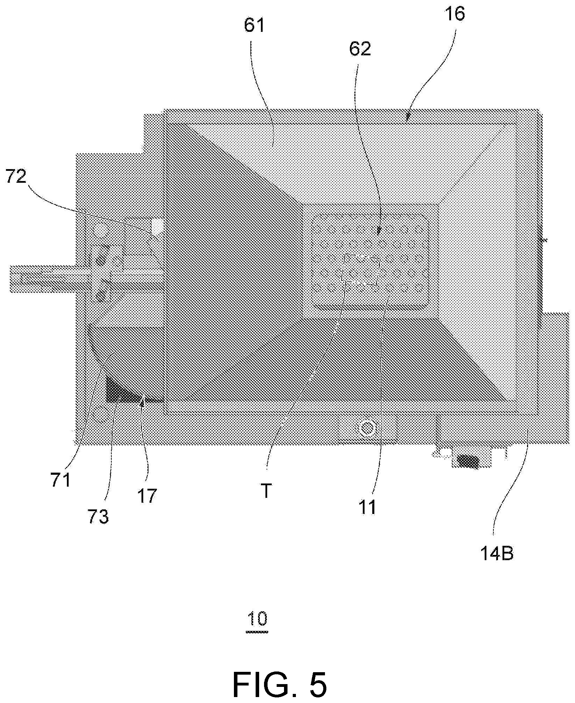

Next, the sieve according to the present invention will be further described with reference to FIG. 5 to FIG. 7. The tablet supply device 10 according to each embodiment of the present invention has one feature that the tablet supply device 10 includes a sieve having holes that do not allow resin tablets to pass through but allow dust smaller than resin tablets to pass through, and do not affect the transport of resin tablets. Various types of sieves can be applied to the sieve according to the present invention as long as the sieves are able to sift dust.

For example, the sieve may be perforated metal (punched metal sheet) formed by drilling holes in a metal plate. The sieve may be an industrial screen in which wavy metal wires are arranged flat with a shift of 1/2 wavelength so that the gaps between adjacent metal wires open in a substantially diamond shape, and the wave peaks are bonded together using resin or the like. The sieve may be wire mesh (welded wire mesh) in which metal wires are arranged in a grid pattern and welded at the intersections. The sieve may be woven wire mesh formed by weaving metal wires. Other types of sieves may also be used. The sieve according to the present invention preferably has a shape with small unevenness and is unlikely to damage resin tablets due to contact with the sieve. The sieve according to the present invention is not limited to metal materials and may be made of resin materials.

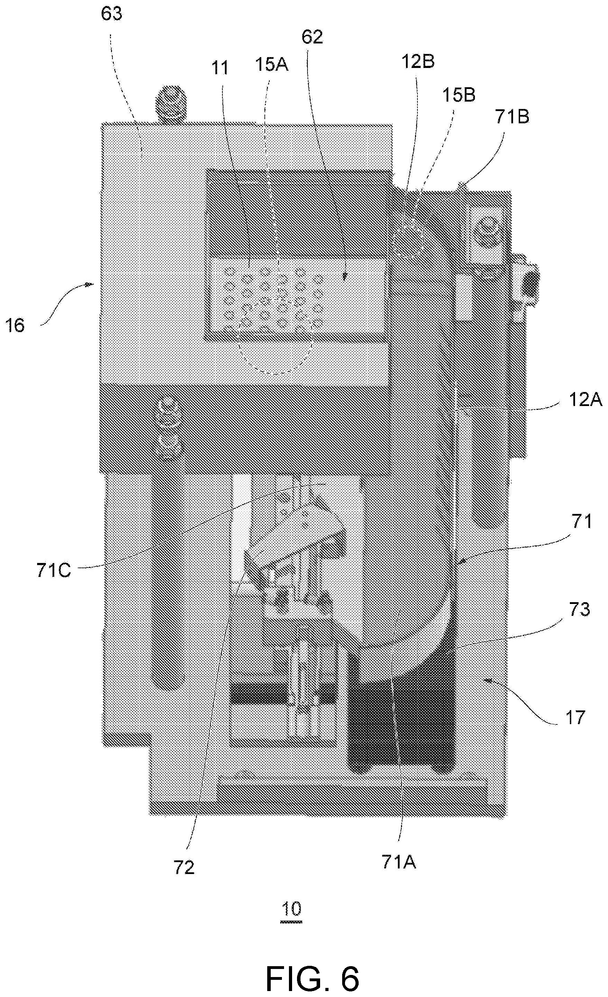

FIG. 5 is a plan view showing the tablet supply device 10 with a lid body 61L of the funnel part 61 shown in FIG. 3 removed. FIG. 6 is a perspective view showing the tablet supply device 10 with the funnel part 61 shown in FIG. 5 removed. As shown in FIG. 5 and FIG. 6, the bottom part 62 of the hopper 16 is provide with a first sieve 11 that does not allow resin tablets to pass through but allows dust smaller than resin tablets to pass through in plan view. An example of resin tablets is indicated by reference numeral T in FIG. 5. The first sieve 11 is an example of the sieve according to the present invention.

The bottom part 62 may include a detachable first tray 13 (shown in FIG. 3) that catches dust that has passed through the first sieve 11. By removing the first tray 13, dust can be collected together. The first tray 13 is not an essential configuration. Instead of the first tray 13, or together with the first tray 13, a suction port 15A connected to a dust collection device capable of suctioning dust through a tubular member such as a duct or hose may be provided below (preferably directly below) the first sieve 11. In the case of suctioning dust caught by the first tray 13 through the suction port 15A, the first tray 13 may have a structure that cannot be removed from the tablet supply device 10. The suction port 15A is an example of a suction mechanism that suctions dust that has passed through the first sieve 11.

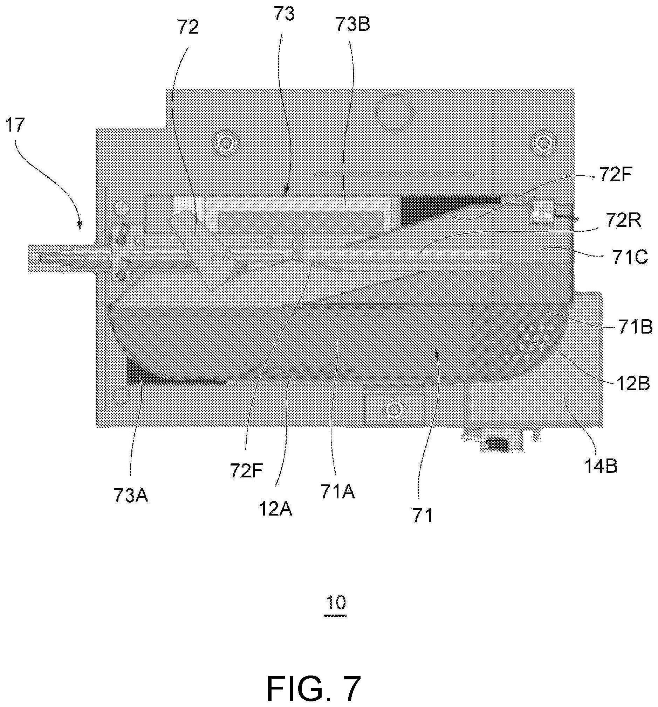

FIG. 7 is a plan view showing the tablet supply device 10 with the hopper 16 shown in FIG. 5 removed. As shown in FIG. 7, second sieves 12A and 12B are provided in at least a partial region of the transport path 71. The second sieves 12A and 12B do not allow resin tablets to pass through but allow dust smaller than resin tablets to pass through in plan view. The second sieves 12A and 12B are examples of the sieve according to the present invention.

The transport path 71 may include a detachable second tray that catches dust that has passed through the second sieves 12A and 12B. In the illustrated example, a second tray 14B that catches dust that has passed through the second sieve 12B is included. The second tray 14B is not an essential configuration. Instead of the second tray 14B, or together with the second tray 14B, a suction port 15B (shown in FIG. 6) of a dust collection device may be provided below (preferably directly below) the second sieve 12. The suction port 15B, like the suction port 15A, is connected to the dust collection device capable of suctioning dust through a tubular member such as a duct or hose. In the case of suctioning dust caught by the second tray 14B through the suction port 15B, the second tray 14B may have a structure that cannot be removed from the tablet supply device 10. The suction port 15B is an example of a suction mechanism that suctions dust that has passed through the second sieve 12.

As shown in FIG. 7, the second linear part 71C is further provided with, in addition to the aforementioned guide 72, a groove 72R extending toward the guide 72, and a flap 72F that guides resin tablets toward the groove 72R. The cross-section of the groove 72R is formed as a concave cylindrical surface having a shape that follows the cylindrical surface of the resin tablets.

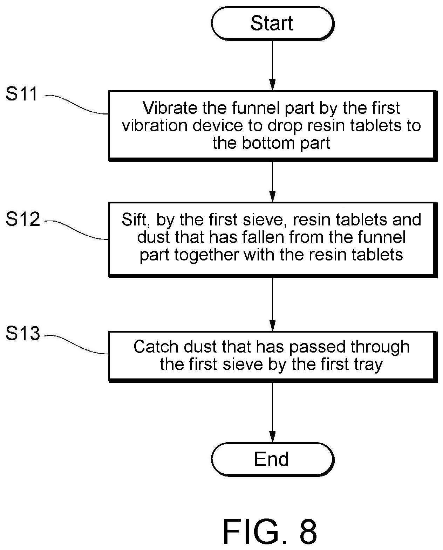

FIG. 8 is a flowchart showing an example of a tablet supply method using the tablet supply device 10 according to one embodiment of the present invention. In the illustrated example, the tablet supply method includes an optional step S13. The tablet supply method, in step S11, vibrates the funnel part 61 in which resin tablets are stored to drop the resin tablets to the bottom part 62.

In step S12, the first sieve 11 provided in the bottom part 62 sifts resin tablets and dust that has fallen from the funnel part 61 together with the resin tablets. The vibration transmitted from the funnel part to the bottom part can efficiently sift resin tablets and dust. In optional step S13, dust that has passed through the first sieve 11 is caught by the first tray.

The tablet supply method shown in FIG. 8 can sift off dust adhering to resin tablets in the hopper 16 by repeating a series of steps S11 to S12. The sifted dust may be collected by optional step S13. The tablet supply method shown in FIG. 8 may omit step S13. Instead of step S13, a step of suctioning dust through a suction port connected to a dust collection device may be included.

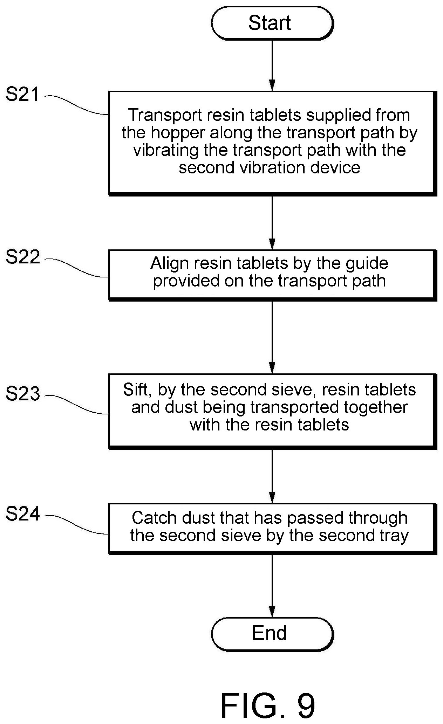

FIG. 9 is a flowchart showing another example of the tablet supply method using the tablet supply device 10 according to one embodiment of the present invention. In the illustrated example, the tablet supply method includes an optional step S24. The tablet supply method, in step S21, transports resin tablets supplied from the hopper 16 and circulates the resin tablets within the transport path 71 along the transport path 71.

As described above, the transport path 71 is provided with the guide 72. In step S22, the resin tablets are aligned by the guide 72 that regulates the orientation of the resin tablets. In the present embodiment, the guide (gate) 72 selectively allows resin tablets to pass through. The guide 72 has an opening that is slightly larger than the diameter of resin tablets when viewed from the transport direction of resin tablets.

In the case of the central axis of a columnar resin tablet being oriented parallel to the X-axis direction, the resin tablet is allowed to pass through the guide 72. In the case of the central axis of a resin tablet being oriented not parallel to the X-axis direction, the resin tablet is not allowed to pass through the guide 72. Resin tablets oriented in a way that are not allowed to pass through the guide 72 come into contact with the guide 72 and fall from the second linear part 71C to the first linear part 71A. The method by which the guide 72 regulates the orientation of resin tablets is not particularly limited. Other methods may be used instead of a method that selectively allows resin tablets to pass through.

In step S23, the second sieves 12A and 12B provided on the transport path 71 sift resin tablets and dust being transported together with the resin tablets. In optional step S24, dust that has passed through the second sieves 12A and 12B is caught by the second tray 14B or the like.

The tablet supply method shown in FIG. 9 can sift off dust adhering to resin tablets in the alignment device 17 by repeating a series of steps S21 to S23. The sifted dust may be collected by optional step S24. Similar to the tablet supply method shown in FIG. 8, step S24 may be omitted, or instead of step S24, a step of suctioning dust through a suction port connected to a dust collection device may be included.

According to the tablet supply device 10 of the present embodiment configured as described above, the resin sealing device 1 including the device, and the tablet supply method using these, resin tablets supplied from the hopper 16 can be sifted from dust by the first sieve 11. Additionally, resin tablets aligned in the alignment device 17 can be sifted from dust by the second sieves 12A and 12B. Since dust adhering to resin tablets is less likely to disperse within the resin sealing device 1, it is possible to prevent in advance dust from adhering to sensors and causing malfunctions, or dust from mixing into workpieces or molds and causing defective products.

The embodiments described above are provided for facilitating understanding of the present invention and are not for limiting interpretation of the present invention. Each element included in the embodiments as well as the arrangement, material, conditions, shape, and size thereof are not limited to those illustrated and can be appropriately modified. Additionally, configurations shown in different embodiments can be partially substituted or combined with each other.

### [Supplementary Note 1]

A tablet supply device 10 includes a hopper 16 that supplies resin tablets used for transfer molding. The hopper 16 includes a funnel part 61 that is capable of storing resin tablets, and a bottom part 62 that catches resin tablets that have fallen from the funnel part 61. The bottom part 62 includes a first sieve 11 that does not allow resin tablets to pass through but allows dust smaller than resin tablets to pass through.

According to the above supplementary note 1, since resin tablets supplied from the hopper 16 can be sifted from dust by the first sieve 11, it is possible to provide the tablet supply device 10 that suppresses dust adhering to resin tablets from dispersing within the resin sealing device 1.

### [Supplementary Note 2]

In the above supplementary note 1, the bottom part 62 may include a first tray 13 that catches dust that has passed through the first sieve 11.

According to the above supplementary note 2, since dust is collected in the first tray 13, the sifted dust is easy to collect when cleaning the hopper 16. The bottom part 62 is less likely to become dirty and the hopper 16 is easy to clean.

### [Supplementary Note 3]

In the above supplementary note 1 or 2, the bottom part 62 may include a suction port 15A that suctions dust that has passed through the first sieve 11.

According to the above supplementary note 3, since dust is collected through the suction port 15A, the sifted dust is easy to collect when cleaning the hopper 16. The bottom part 62 is less likely to become dirty and the hopper 16 is easy to clean.

### [Supplementary Note 4]

In any one of the above supplementary notes 1 to 3, the hopper 16 may further include a first vibration device 63 that causes resin tablets in the funnel part 61 to fall to the bottom part 62 by vibrating the funnel part 61.

According to the above supplementary note 4, since the funnel part 61 is vibrated, resin tablets are less likely to clog at the foot of the funnel part 61. Resin tablets can be reliably dropped from the funnel part 61 to the bottom part 62. Resin tablets and dust can be efficiently sifted by the vibration transmitted from the funnel part to the bottom part.

### [Supplementary Note 5]

In any one of the above supplementary notes 1 to 4, an alignment device 17 may be further included that aligns resin tablets supplied from the hopper 16. The alignment device 17 may include a transport path 71 that transports resin tablets toward a guide 72 that regulates the orientation of the resin tablets, and at least a partial region of the transport path 71 may be provided with second sieves 12A and 12B that do not allow resin tablets to pass through but allow dust smaller than resin tablets to pass through.

According to the above supplementary note 5, dust adhering to resin tablets can be collected in the alignment device 17 in addition to the hopper 16. Dust within the resin sealing device 1 can be suppressed from dispersing more reliably.

### [Supplementary Note 6]

In the above supplementary note 5, the transport path 71 may include a second tray 14B that catches dust that has passed through the second sieve 12B.

According to the above supplementary note 6, since dust is collected in the second tray 14B, the sifted dust is easy to collect when cleaning the alignment device 17. The second vibration device 73 or the like is less likely to become dirty and the alignment device 17 is easy to clean.

### [Supplementary Note 7]

In the above supplementary note 5 or 6, the transport path 71 may be provided with a suction port 15B that suctions dust that has passed through the second sieve 12B.

According to the above supplementary note 7, since dust is collected through the suction port 15B, the sifted dust is easy to collect when cleaning the alignment device 17. The second vibration device 73 or the like is less likely to become dirty and the alignment device 17 is easy to clean.

### [Supplementary Note 8]

In any one of the above supplementary notes 5 to 7, the alignment device 17 may further include a second vibration device 73 that transports resin tablets in the transport path 71 by vibrating the transport path 71, and the second sieves 12A and 12B may be provided in a non-overlapping region V that does not overlap in plan view with a connection part 74 between the transport path 71 and the second vibration device 73.

According to the above supplementary note 8, since the connection part 74 does not occupy the space directly below the non-overlapping region V, the second tray 14B, the suction port of the dust collection device or the like can be arranged in the available space to collect dust.

### [Supplementary Note 9]

A tablet supply device 10 includes a hopper 16 that supplies resin tablets used for transfer molding, and an alignment device 17 that aligns resin tablets supplied from the hopper 16. The alignment device 17 includes a transport path that transports resin tablets toward a guide that regulates the orientation of the resin tablets. At least a partial region of the transport path is provided with a second sieve that does not allow resin tablets to pass through but allows dust smaller than resin tablets to pass through.

According to the above supplementary note 9, since resin tablets aligned in the alignment device 17 can be sifted from dust by the second sieves 12A and 12B, it is possible to provide the tablet supply device 10 that suppresses dust adhering to resin tablets from dispersing within the resin sealing device 1.

### [Supplementary Note 10]

It may further include the tablet supply device 10 according to any one of the above supplementary notes 1 to 9, a mold 30 that melts resin tablets to seal an electronic component with resin, and a loader 51 that transports resin tablets supplied from the tablet supply device 10 into the mold 30.

According to the above supplementary note 10, it is possible to provide the resin sealing device 1 that suppresses dust from dispersing within the resin sealing device 1. It is possible to prevent in advance dust from adhering to sensors and causing malfunctions, or dust from mixing into workpieces or molds and causing defective products.

### [Supplementary Note 11]

A tablet supply method includes vibrating a funnel part 61 in which resin tablets are stored to drop the resin tablets to a bottom part 62, and sifting resin tablets and dust that has fallen from the funnel part 61 together with the resin tablets by a first sieve 11 provided in the bottom part 62.

According to the above supplementary note 11, since resin tablets supplied from the hopper 16 can be sifted from dust by the first sieve 11, it is possible to provide a tablet supply method that suppresses dust adhering to resin tablets from dispersing within the resin sealing device 1.

### [Supplementary Note 12]

A tablet supply method includes transporting resin tablets supplied from a hopper 16 along a transport path 71, aligning resin tablets by a guide 72 provided on the transport path 71, and sifting resin tablets and dust being transported together with the resin tablets by second sieves 12A and 12B provided on the transport path 71.

According to the above supplementary note 12, since resin tablets aligned in the alignment device 17 can be sifted from dust by the second sieves 12A and 12B, it is possible to provide a tablet supply method that suppresses dust adhering to resin tablets from dispersing within the resin sealing device 1.

### Description of Reference Numerals

1...resin sealing device, 2...in-module, 3...press module, 4...out-module, 10...tablet supply device, 11...first sieve (example of sieve), 12A, 12B...second sieve (another example of sieve), 13...first tray (example of tray), 14B...second tray (another example of tray), 15A, 15B... suction port (example of suction mechanism), 16...hopper, 17...alignment device, 18...lifting device, 20...workpiece supply device, 21...supply magazine, 30...mold, 41...degater, 42...workpiece storage device, 43...storage magazine, 50...guide rail, 51...loader, 52...unloader, 61...funnel part, 61L...lid body, 62...bottom part, 63...first vibration device, 71...transport path, 71A...first linear part, 71B...corner part, 71C...second linear part, 72...guide, 72F...flap, 72R...groove, 73...second vibration device, 73A...first vibration part, 73C...second vibration part, 74...connection part, 91, 92, 93...frame, T...resin tablet, V...non-overlapping region, W...overlapping region.

## Claims

1. A tablet supply device, comprising a hopper that supplies resin tablets used for transfer molding,
wherein the hopper comprises:
a funnel part that is capable of storing resin tablets; and
a bottom part that catches resin tablets that have fallen from the funnel part,
wherein the bottom part comprises a sieve that does not allow resin tablets to pass through but allows dust smaller than resin tablets to pass through.

2. The tablet supply device according to claim 1, wherein the bottom part comprises a tray that catches dust that has passed through the sieve.

3. The tablet supply device according to claim 1, wherein the bottom part comprises a suction mechanism that suctions dust that has passed through the sieve.

4. The tablet supply device according to claim 1, wherein the hopper further comprises a vibration device that causes resin tablets in the funnel part to fall to the bottom part by vibrating the funnel part.

5. The tablet supply device according to claim 1, further comprising an alignment device that aligns resin tablets supplied from the hopper,
wherein the alignment device comprises:
a transport path that transports resin tablets toward a guide that regulates an orientation of the resin tablets, and
at least a partial region of the transport path is provided with a second sieve that does not allow resin tablets to pass through but allows dust smaller than resin tablets to pass through.

6. The tablet supply device according to claim 5, wherein the transport path comprises a second tray that catches dust that has passed through the second sieve.

7. The tablet supply device according to claim 5, wherein the transport path is provided with a suction mechanism that suctions dust that has passed through the second sieve.

8. The tablet supply device according to claim 5, wherein the alignment device further comprises a second vibration device that transports resin tablets in the transport path by vibrating the transport path, and
the second sieve is provided in a region that does not overlap in plan view with a connection part between the transport path and the second vibration device.

9. A tablet supply device, comprising a hopper that supplies resin tablets used for transfer molding, and an alignment device that aligns resin tablets supplied from the hopper,
wherein the alignment device comprises:
a transport path that transports resin tablets toward a guide that regulates an orientation of the resin tablets, and
at least a partial region of the transport path is provided with a sieve that does not allow resin tablets to pass through but allows dust smaller than resin tablets to pass through.

10. A resin sealing device, comprising the tablet supply device according to any one of claims 1 to 9, and further comprising:
a mold that melts resin tablets to seal an electronic component with resin; and
a loader that transports resin tablets supplied from the tablet supply device into the mold.

11. A tablet supply method, comprising:
vibrating a funnel part in which resin tablets are stored to drop the resin tablets to a bottom part; and
sifting resin tablets and dust that has fallen from the funnel part together with the resin tablets by a sieve provided in the bottom part.

12. A tablet supply method, comprising:
transporting resin tablets supplied from a hopper along a transport path;
aligning resin tablets by a guide provided on the transport path; and
sifting resin tablets and dust being transported together with the resin tablets by a sieve provided on the transport path.
